# EUROPÄISCHE PATENTSCHRIFT

(11) **EP 0 328 773 B1**
(45) Veröffentlichungstag und Bekanntmachung des Hinweises auf die Patenterteilung: **13.04.1994**
(21) Anmeldenummer: 88121264.1
(22) Anmeldetag: 20.12.1988
(51) Int. Cl.: G06K 7/10, H03J 9/06

(54) **Fernbedienungsgeber mit Strichcodeleser**
Remotely controlled transmitter with a bar code reader
Transmetteur de télécommande avec lecteur de code à barres

(30) Priorität: 19.02.1988 DE 3805174
(43) Veröffentlichungstag der Anmeldung: 23.08.1989
(73) Patentinhaber: GRUNDIG E.M.V. Elektro-Mechanische Versuchsanstalt Max Grundig holländ. Stiftung & Co. KG., D-90762 Fürth (DE)
(72) Erfinder: Kornhaas, Wolfgang Grundig E.M.V. Max Grundig, D-8510 Fürth/Bay (DE)
(74) Vertreter: Eichstädt, Alfred

(56) Entgegenhaltungen:
- EP-A- 0 052 306
- EP-A- 0 098 956
- EP-A- 0 254 517
- GB-A- 2 185 840
- US-A- 4 631 601

## Beschreibung

Die Erfindung betrifft einen Fernbedienungsgeber mit den im Oberbegriff des Patentanspruchs 1 angegebenen Merkmalen.

Aus der EP-Anmeldung 0098956 ist ein Fernbedienungsgeber bekannt, in welchen die Optik eines Strichcodelesers integriert ist. Ein derartiger Fernbedienungsgeber kann in vorteilhafter Weise zusätzlich zu seinen üblichen Aufgaben (Bedienung eines oder mehrerer Geräte der Unterhaltungselektronik) dazu verwendet werden, einen Strichcode, der in einer Programmzeitschrift abgedruckt ist und sendungsspezifische Daten wie Sendetag, Sendezeit, Sendeanstalt, usw. beinhaltet, zu lesen und im Sinne einer Programmierung in einen Speicher z.B. eines Videorecorders zu übertragen. Ein Nachteil dieses Fernbedienungsgebers besteht darin, daß der gelesene Strichcode nicht auf seine Richtigkeit hin überprüft werden kann, so daß unter Umständen fehlerhafte Daten in den Speicher des Videorecorders übertragen werden. Dies führt dazu, daß der gewünschte Programmbeitrag nicht aufgezeichnet wird.

Aus der EP-A2-0 254 517 ist ein Barcodeleser zur Programmierung von Videorecordern bekannt. Der bekannte Barcodeleser weist einen Tongenerator auf, mittels dessen dem Benutzer das korrekte Lesen des Barcodes akustisch signalisiert wird.

Weiterhin ist aus der GB-A-21 85 840 ein Mikrowellenherd mit einer Fernbedienung bekannt. Diese Fernbedienung enthält einen Barcodeleser und eine Anzeige, auf der die eingegebenen Barcodesignale im Klartext dargestellt werden können.

Ausgehend von diesem Stand der Technik liegt der Erfindung die Aufgabe zugrunde, einen Fernbedienungsgeber der eingangs genannten Art derart weiterzubilden, daß der vom Strichcodeleser gelesene Strichcode vor der Übertragung in den Speicher des zu programmierenden Empfängers auf seine Richtigkeit hin überprüft werden kann.

Diese Aufgabe wird bei einem Fernbedienungsgeber mit den im Oberbegriff des Anspruchs 1 angegebenen Merkmalen durch die im kennzeichnenden Teil angegebenen Merkmale gelöst. Vorteilhafte Ausgestaltungen der Erfindung ergeben sich aus den Unteransprüchen.

Die Vorteile der Erfindung bestehen insbesondere darin, daß im beanspruchten Fernbedienungsgeber eine Decodierung des gelesenen Strichcodes erfolgt und ein eventueller Fehler im Klartext auf dem Display des Fernbedienungsgebers angezeigt wird. Ein eventueller Fehler beim Lesen des Strichcodes kann auf diese Weise vor der Übertragung des Strichcodes in den Speicher des Empfangsgerätes erkannt und korrigiert werden. Dadurch wird sichergestellt, daß die gewünschte Sendung auch tatsächlich aufgezeichnet wird. Weitere vorteilhafte Eigenschaften des beanspruchten Fernbedienungsgebers ergeben sich aus einem Ausführungsbeispiel, welches im folgenden anhand der (einzigen) Figur näher erläutert wird.

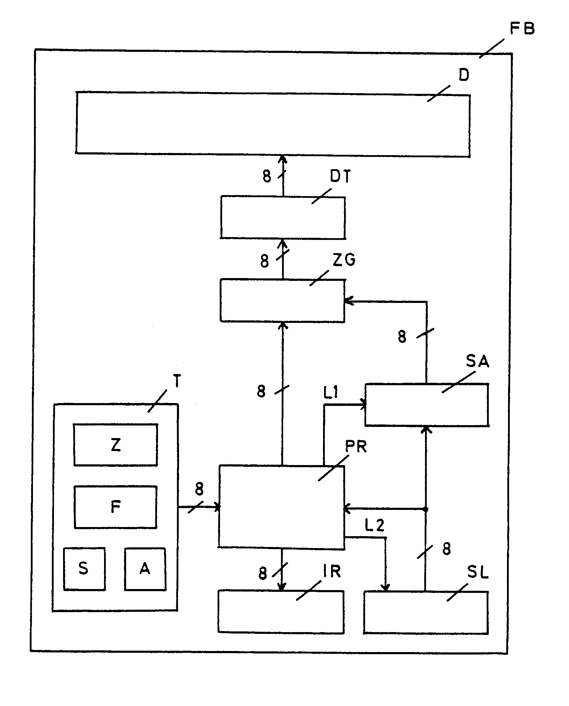

Der in der Figur gezeigte Fernbedienungsgeber FB enthält eine Tastatur T, welche neben den üblichen Ziffern- und Funktionstasten Z bzw. F eine Sendetaste S und eine Strichcodeleseraktivierungstaste A aufweist. Mittels der Ziffern- und Funktionstasten werden die üblichen Bedienungsbefehle eines Videorecorders eingegeben. Dazu gehören Einschalten aus dem Bereitschaftsbetrieb, normale Wiedergabe, schneller Suchlauf vorwärts, schneller Suchlauf rückwärts, Umspulen vorwärts, Umspulen rückwärts, Standbildwiedergabe sowie die manuelle Programmierung. Die über die Ziffern- und Funktionstasten eingegebenen Befehle werden über eine 8-Bit-Leitung einem Prozessor PR zugeführt, dort in ein codiertes Signal, zum Beispiel ein biphasecodiertes Signal, umgewandelt und bei Betätigen der Sendetaste S über einen Infrarot-Sender IR zum (nicht gezeichneten) Videorecorder übertragen. Ferner werden die über die Ziffern- und Funktionstasten eingegebenen Bedienbefehle im Prozessor PR in ASCII-Datenwörter umgewandelt. Diese werden einem Zeichengenerator ZG zugeführt. Im Zeichengenerator werden aus den ASCII-Datenwörtern Buchstaben und Ziffer gewonnen, die über einen Display-Treiber DT auf einem Display D als die Bedienbefehle beschreibende Klartextsignale dargestellt werden.

Bei Betätigung der Strichcodeleseraktivierungstaste A der Tastatur T wird vom Prozessor über eine Leitung L2 ein Strichcodeleser SL aktiviert. Die vom Strichcodeleser SL beim Überstreichen eines in einer Programmzeitschrift abgedruckten Strichcodes gelesenen Strichcodedaten werden einerseits dem Prozessor PR und andererseits einer Strichcodeauswerteschaltung SA zugeführt. Der Prozessor PR überprüft, ob die Strichcodedaten vollständig und korrekt codiert sind, z.B. ob am Anfang jedes Datenwortes ein Startbit vorhanden ist, ob der Code vollständig gelesen wurde, usw.

Ist dies der Fall, dann erzeugt der Prozessor PR ein Freigabesignal, welche der Strichcodeauswerteschaltung SA über eine Leitung L1 zugeführt wird. In der Strichcodeauswerteschaltung SA werden die codierten Strichcodedaten in ASCII-Datenwörter umgewandelt. Diese werden dem Zeichengenerator ZG zugeführt. Im Zeichengenerator werden aus den ASCII-Datenwörtern Buchstaben und Ziffern gewonnen, die über den Display-Treiber DT auf dem Display D als den gelesenen Strichcode beschreibende Klartextsignale dargestellt werden.

Liegen hingegen unkorrekte und/oder unvollständige Strichcodedaten vor, dann erzeugt der Prozessor PR ein Sperrsignal, welches der Strichcodeauswerteschaltung SA über die Leitung L1 zugeführt wird. Dies bewirkt, daß eine Auswertung der Strichcodedaten in der Strichcodeauswerteschaltung SA unterbleibt. Ferner erzeugt der Prozessor in diesem Fall ASCII-Datenwörter, welche Informationen über das Vorhandensein eines Fehlers und dessen Art (z.B. Fehlen des Startbits, Code unvollständig, ...) geben. Diese ASCII-Datenwörter werden dem Zeichengenerator ZG zugeführt. Im Zeichengenerator werden aus den ASCII-Datenwörtern Buchstaben und Ziffern gewonnen, die über den Display-Treiber DT auf dem Display D als den Fehler beschreibende Klartextsignale dargestellt werden.

Anhand dieses auf dem Display D angezeigten Klartextes, welcher bei korrektem Strichcode das decodierte Strichcodesignal und bei fehlerhaftem Strichcode eine Fehlermeldung darstellt, kann der Benutzer vor dem Absenden der Strichcodeinformation überprüfen, ob der Strichcode vom Strichcodeleser richtig gelesen wurde oder nicht. Ist dies nicht der Fall, dann kann der Benutzer den Lesevorgang ggf. wiederholen, bis korrekte Strichcodedaten vorliegen. Dadurch wird eine korrekte Programmierung des Videorecorders sichergestellt.

## Patentansprüche

1. Fernbedienungsgeber (FB), mit
- einer Tastatur (T) zur Eingabe von Befehlen,
- einem mit der Tastatur verbundenen Prozessor (PR) zur Umwandlung der über die Tastatur (T) eingegebenen Befehle in ein codiertes Signal,
- einem Infrarot-Sender (IR) zur Aussendung des codierten Signals,
- einem Strichcodeleser (SL), dessen Ausgangssignale dem Prozessor (PR) zugeführt werden,
- einer Strichcodeauswerteschaltung (SA) zur Decodierung des Ausgangssignals des Strichcodelesers (SL),
- einem Zeichengenerator (ZG), welchem das Ausgangssignal der Strichcodeauswerteschaltung (SA) zugeführt wird, und
- einem an den Ausgang des Zeichengenerators (ZG) angeschlossenen Display (D), auf dem das decodierte Strichcodesignal im Klartext dargestellt wird,
**dadurch gekennzeichnet,** daß der Fernbedienungsgeber (FB) so ausgestaltet ist, daß
- die Ausgangssignale des Strichcodelesers (SL) im Prozessor (PR) auf eine korrekte und vollständige Codierung hin überprüft werden,
- der Prozessor (PR) bei unkorrekter und/oder unvollständiger Codierung der Ausgangssignale des Strichcodelesers (SL) der Strichcodeauswerteschaltung (SA) über eine Leitung (L1) ein Sperrsignal zuführt, und
- auf dem Display (D) unter Steuerung durch den Prozessor (PR) eine die Fehlerart beschriebende Fehlermeldung im Klartext dargestellt wird.

2. Fernbedienungsgeber nach Anspruch 1,
**dadurch gekennzeichnet,** daß der Prozessor (PR) bei korrekter und vollständiger Codierung der Ausgangssignale des Strichcodelesers (SL) der Strichcodeauswerteschaltung (SA) über eine Leitung (L1) ein Freigabesignal zuführt.

3. Fernbedienungsgeber nach Anspruch 1 oder 2,
**dadurch gekennzeichnet,** daß er eine Taste (A) enthält, bei deren Betätigung der Strichcodeleser (SL) über eine Leitung (L2) aktiviert wird.

## Claims

1. Remote-control transmitter (FB), having
- a keypad (T) for the entry of commands,
- a processor (PR), connected to the keypad, for conversion of the commands entered by means of the keypad (T) into a coded signal,
- an infrared transmitter (IR) for transmission of the coded signal,
- a bar-code reader (SL), the output signals of which are fed to the processor (PR),
- a bar-code evaluation circuit (SA) for decoding of the output signal of the bar-code reader (SL),
- a character generator (ZG), to which the output signal of the bar-code evaluation circuit (SA) is fed, and
- a display (D) which is connected to the output of the character generator (ZG) and on which the decoded bar-code signal is represented in clear text,
characterized in that the remote-control transmitter (FB) is designed in such a way that
- the output signals of the bar-code reader (SL) are checked in the processor (PR) for correct and complete coding,
- in the event of incorrect and/or incomplete coding of the output signals of the bar-code reader (SL), the processor (PR) feeds a disable signal to the bar-code evaluation circuit (SA) via a line (L1), and
- an error message describing the nature of the error is represented in clear text on the display (D) under the control of the processor (PR).

2. Remote-control transmitter according to Claim 1, characterized in that, in the event of correct and complete coding of the output signals of the bar-code reader (SL), the processor (PR) feeds an enable signal to the bar-code evaluation circuit (SA) via a line (L1).

3. Remote-control transmitter according to Claim 1 or 2, characterized in that it includes a key (A) which, when actuated, activates the bar-code reader (SL) via a line (L2).

## Revendications

1. Générateur de télécomrande (FB), comportant
- un clavier (T) pour entrer des instructions,
- un processeur (PR) relié au clavier et servant à convertir les instructions produites au moyen du clavier (T) en un signal codé,
- un émetteur à infrarouge (IR) servant à émettre le signal codé,
- un lecteur (SL) de code à barres, dont les signaux de sortie sont envoyés au processeur (PR),
- un circuit (SA) d'évaluation du code à barres servant à décoder le signal de sortie du lecteur (SL) de code à barres,
- un générateur de caractères (ZG), auquel est envoyé le signal de sortie du circuit (SA) d'évaluation du code à barres, et
- un dispositif d'affichage (D), qui est raccordé à la sortie du générateur de caractères (ZG) et sur lequel le signal de code à barres décodé est représenté en clair,
caractérisé en ce que le générateur de télécommande (FB) est agencé de telle sorte que
- les signaux de sortie du lecteur (SL) de code à barres dans le processeur (PR) sont contrôlés pour déterminer s'ils possèdent un codage correct et complet,
- dans le cas d'un codage incorrect et/ou incomplet des signaux de sortie du lecteur (SL) de code à barres, le processeur (PR) envoie un signal de blocage au circuit (SL) d'évaluation du code à barres par l'intermédiaire d'une ligne (L1), et
- une signalisation d'erreur, qui décrit le type d'erreur, est représentée en clair sur le dispositif d'affichage (D), sous la commande du processeur (PR).

2. Générateur de télécommande suivant la revendication 1, caractérisé en ce que dans le cas d'un codage correct et complet des signaux de sortie du lecteur (SL) de code à barres, le processeur (PR) envoie un signal de libération au circuit (SA) d'évaluation du code à barres, par l'intermédiaire d'une ligne (L1).

3. Générateur de télécommande selon la revendication 1 ou 2, caractérisé en ce qu'il contient une touche (A), lors de l'actionnement de laquelle le lecteur (SL) de code à barres est activé par l'intermédiaire d'une ligne (L2).
